# EUROPÄISCHE PATENTSCHRIFT

(11) **EP 1 607 810 B1**
(45) Veröffentlichungstag und Bekanntmachung des Hinweises auf die Patenterteilung: **30.09.2009**
(21) Anmeldenummer: 04013405.8
(22) Anmeldetag: 07.06.2004
(51) Int. Cl.: G05B 19/042, G05B 19/05

(54) **Wartungsfähige elektrische Anlage**
Serviceable electrical equipment
Equipement électrique d'entretien facile

(43) Veröffentlichungstag der Anmeldung: 21.12.2005
(73) Patentinhaber: SIEMENS AKTIENGESELLSCHAFT, 80333 München (DE)
(72) Erfinder: Grosser, Stefan, 92253 Schnaittenbach (DE); Hirmer, Gerald, 92708 Mantel (DE); Maier, Mario, 92266 Ensdorf (DE)

(56) Entgegenhaltungen:
- EP-A- 1 041 476
- DE-A- 19 633 744
- US-A- 5 984 498
- US-B1- 6 297 612

## Beschreibung

Die vorliegende Erfindung betrifft eine elektrische Anlage, insbesondere ein Automatisierungsgerät, wie beispielsweise eine speicherprogrammierbare Steuerung (SPS). Darüber hinaus betrifft die Erfindung ein Verfahren zum Betrieb einer solchen Anlage.

Speicherprogrammierbare Steuerungen und andere modular aufgebaute elektrische Anlagen zur Datenverarbeitung oder dergleichen benötigen zur Datenübertragung zwischen ihren einzelnen Baugruppen ein Bussystem. An dieses Bussystem werden eine ganze Reihe verschiedener Anforderungen gestellt, beispielsweise hinsichtlich Modularität und Flexibilität (selbstaufbauendes Bussystem). Darüber hinaus wird angestrebt, dass mindestens eine Baugruppe im Wartungsfall austauschbar ist (Ziehen und Stecken), ohne dass der Betrieb der anderen Baugruppen beeinträchtigt wird. Dies wird im Stand der Technik durch Systeme mit Mehr-Punkt-Verbindungen (beispielsweise mit einem "Sender" und zwei "Empfängern") erreicht. Von Nachteil dabei sind jedoch die aufgrund der vorhandenen Verzweigungen und der damit verbundenen Impedanzsprünge stark eingeschränkten Übertragungsraten bei der Datenübertragung.

In US 6,297,612 ist ein Steuerungssystem für eine Anzahl von Servomotoren beschrieben. Darin sind die den einzelnen Servomotoren zugeordneten Steuermodule derart miteinander verdrahtet, dass die zentrale Steuereinheit über Punkt-zu-Punkt-Verbindungen mit jedem einzelnen Steuermodul verbunden ist. Dadurch wird erreicht, dass die einzelnen Steuermodule in beliebiger Reihenfolge angeordnet werden können.

In DE 19633744 ist eine ringförmige Kommunikationsstruktur beschrieben. Darin sind Signalverarbeitungseinheiten über Sende- und Empfangorgane reihum zur Kommunikation miteinander gekoppelt, wobei Kommunikationsüberbrückungspfade verwendet werden, die von einer Signalverarbeitungseinheit zu der jeweils übernächsten Signalverarbeitungseinheit verlaufen. Dabei sind jeder Signalverarbeitungseinheit jeweils zwei Sender und zwei Empfänger zugeordnet, so daß im Fehlerfall, wenn also kein Empfang von dem nächstliegend sendenden Nachbarknoten möglich ist, der Sendestrom des übernächstliegenden Knotens verwendet werden kann.

Aufgabe der vorliegenden Erfindung ist es, eine modulare elektrische Anlage, insbesondere Automatisierungsgerät, mit einem verbesserten Wartungsverhalten zu schaffen.

Diese Aufgabe wird durch eine elektrische Anlage nach Anspruch 1 bzw. durch ein Verfahren nach Anspruch 4 gelöst. Danach weist die elektrische Anlage eine Anzahl über Busmodule elektrisch leitend miteinander verbindbaren Baugruppen auf, wobei im verbundenen Zustand jede Baugruppe eine Punkt-zu-Punkt-Verbindung sowohl zu ihrer unmittelbar benachbarten Baugruppe, als auch zu deren benachbarter Baugruppe aufweist, sofern eine jeweils benachbarte Baugruppe vorhanden ist, und ist dadurch gekennzeichnet, dass jede Baugruppe ein Hauptregister und ein Schattenregister aufweist, wobei die Register von den bei einer Datenübertragung zwischen den Baugruppen übertragenen Daten durchlaufen werden, wobei die Hauptregister derart miteinander verbunden sind, dass eine Datenübertragung von einem Hauptregister einer Baugruppe in das Hauptregister einer benachbarten Baugruppe erfolgt, wobei jeweils die Schattenregister zweier nicht unmittelbar benachbarter Baugruppen über eine Punkt-zu-Punkt-Verbindung miteinander verbunden sind, und wobei jeweils die Schattenregister zweier nicht unmittelbar benachbarter Baugruppen über eine Punkt-zu-Punkt-Verbindung miteinander verbunden sind, sofern eine solche Baugruppe vorhanden ist, und wobei die Register miteinander verbunden sind derart, dass Daten von dem Schattenregister in das Hauptregister transferiert werden, wenn in dem Hauptregister keine gültigen Daten vorliegen.

Ein Kerngedanke der Erfindung ist es, durch geeignete Verbindungen zwischen Baugruppen der Anlage einen Austausch einzelner Baugruppen zu ermöglichen, ohne den Betrieb anderer Baugruppen zu beeinträchtigen. Diese geeigneten Verbindungen sind als Punkt-zu-Punkt-Verbindungen (also Verbindungen mit einem einzigen "Sender" und einem einzigen "Empfänger") ausgeführt. Da somit keine Abzweige (wie bei Mehr-Punkt-Verbindungen) existieren, welche zu Impedanzsprüngen und Reflexionen der Übertragungssignale führen würden, ist es in der vorliegenden elektrischen Anlage sehr einfach, definierte Impedanzwerte für die einzelnen Verbindungsleitungen zu realisieren, so dass sehr hohe Datenübertragungsraten und damit ein verbessertes Betriebsverhalten im Wartungsfall erreicht werden.

Es ist vorgesehen, dass eine Baugruppe eine Punkt-zu-Punkt-Verbindung sowohl zu ihrer unmittelbar benachbarten Baugruppe, als auch zu deren benachbarter Baugruppe aufweist. Mit anderen Worten besteht dann einerseits eine Punkt-zu-Punkt-Verbindung von einer ersten Baugruppe zu einer dieser ersten Baugruppe am nächsten angeordneten zweiten Baugruppe als auch andererseits von der ersten Baugruppe zu einer übernächsten dritten Baugruppe. Vorzugsweise sind alle Baugruppen der elektrischen Anlage in dieser Art und Weise miteinander verbunden, sofern eine jeweils nächste bzw. übernächste Baugruppe vorhanden ist. Ein Ziehen und Stecken einer Baugruppe im laufenden Betrieb des Bussystems, wie es beispielsweise für Wartungsarbeiten erforderlich ist, ist dann problemlos möglich. Dabei spielt es keine Rolle, ob eine oder auch mehrere Baugruppen gezogen bzw. gesteckt werden. Für den Fall, dass mehr als eine Baugruppe gezogen wird, ist lediglich darauf zu achten, dass die gezogenen Baugruppen keine unmittelbar zueinander benachbarten Baugruppen sind.

Insbesondere werden zwei nicht unmittelbar benachbarte Baugruppen über eine Punkt-zu-Punkt-Verbindung zwischen ihren Schattenregistern miteinander verbunden. Dieser Aufbau gewährleistet trotz des Überspringens einer "gezogenen" (zweiten) Baugruppe eine sichere Übertragung von Daten von einer (ersten) Baugruppe zu einer anderen (dritten) Baugruppe und stellt somit die Weitergabe der Daten an die nächste (vierte) Baugruppe der Anlage sicher.

Vorteilhafte Ausführungen der Erfindung sind in den Unteransprüchen angegeben.

Besonders vorteilhaft ist es, wenn die Busmodule (vorzugsweise sämtliche Busmodule der Anlage) ausschließlich passive Elemente mit einer sehr geringen Ausfallrate, wie beispielsweise Steckverbinder und Leiterplatten, aufweisen. Die aktive Elektronik, die in der Regel eine höhere Ausfallrate aufweist, befindet sich mit anderen Worten ausschließlich in den Baugruppen und kann während des Betriebes ausgewechselt werden. Durch die passive Ausgestaltung der Busmodule wird die Ausfallrate erheblich reduziert und die Verfügbarkeit des Systems deutlich erhöht.

Erfindungsgemäß ist es vorgesehen, dass das Bussystem vom Anwender erst während der Montage der einzelnen Baugruppen aufgebaut wird. Dadurch können beispielsweise unterschiedlich breite Baugruppen gesteckt werden. Ebenso ist die Anzahl der steckbaren Baugruppen variabel. Zudem besteht keine Einschränkung im Hinblick auf die Anzahl der maximal steckbaren Baugruppen. Ein weiterer Vorteil besteht darin, dass eine bereits bestehende elektrische Anlage während des Betriebes um zusätzliche Baugruppen problemlos erweitert werden kann.

Besonders vorteilhaft ist es, wenn von der Zentraleinheit (CPU) der Anlage bei einem Hochlauf des Systems der jeweilige Busausbau eingelesen wird (automatische Adressvergabe).

Wird die Funktionalität von Ziehen und Stecken nicht benötigt, ist es möglich, auf drei Baugruppen gleichzeitig zugreifen. Somit ergibt sich für diese Betriebsart die dreifache Datenübertragungsrate.

Die Erfindung wird nachfolgend anhand von Ausführungsbeispielen näher beschrieben, die mit Hilfe der Zeichnungen erläutert werden. Hierbei zeigen:
- FIG 1: eine perspektivische Darstellung einer elektrischen Anlage mit zwei Busmodulen und einer Baugruppe,
- FIG 2: eine schematische Darstellung einer elektrischen Anlage mit fünf Busmodulen und dazugehörigen Baugruppen und
- FIG 3: eine schematische Darstellung einer elektrischen Anlage mit einer CPU anstelle eines Busmoduls.

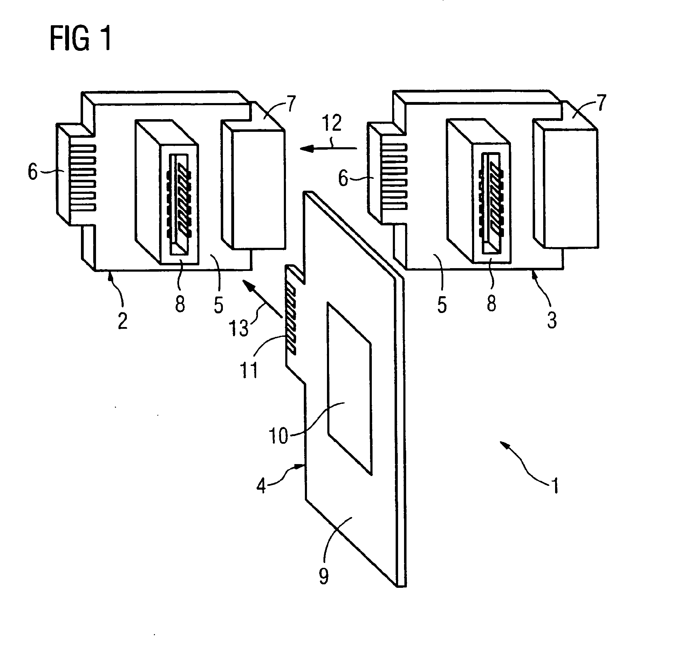

FIG 1 zeigt auf vereinfachte Art und Weise einen Teil eines Automatisierungsgerätes 1 mit zwei miteinander verbindbaren Busmodulen 2, 3 und einer auf das erste Busmodul 2 aufsteckbaren Baugruppe 4 in Explosionsdarstellung. Die Busmodule 2, 3 sind rein passiv aufgebaut. Mit anderen Worten wird ein passives Rückwandbus-System verwendet. Jedes Busmodul 2, 3 umfasst eine Leiterplatte 5 und drei auf der Leiterplatte 5 angebrachte Steckverbinder 6, 7, 8. Dabei sind zwei Steckverbinder 7, 8 zur Kontaktierung benachbarter Busmodule 2, 3 und ein dritter Steckverbinder 8 zur Kontaktierung einer Baugruppe 4 vorgesehen. Auf der Leiterplatte 5 sind, wie weiter unten ausführlich beschrieben, Leiterbahnen (nicht abgebildet) angebracht, die der elektrischen Verbindung der Steckverbinder 6, 7, 8 untereinander dienen. Jedes Busmodul 2, 3 ist auf einer Trägerplatte (nicht abgebildet) montiert, beispielsweise mittels einer Schnappverbindung.

Die Baugruppe 4 umfasst eine Leiterplatte 9 (Peripherieleiterplatte), auf der die Elektronik 10, beispielsweise in Form eines ASIC (Application-Specific Integrated Circuit) angeordnet ist. Darüber hinaus umfasst die Baugruppe 4 einen Steckverbinder 11 zur Kontaktierung des Busmoduls 2. Das die Baugruppe 4 umschließende Kunststoffgehäuse ist aus Gründen der Übersichtlichkeit nicht abgebildet. Die Busmodule 2, 3 sind untereinander durch einfaches Zusammenschieben der Steckverbinder 6, 7 in Steckrichtung 12 und die Baugruppe 4 mit dem Busmodul 2 durch einfaches Zusammenschieben der Steckverbinder 11, 8 in Steckrichtung 13 kontaktierbar.

Die eingezeichneten Steckerkontakte (Pins) der Steckverbinder 6, 7, 8, 11 dienen lediglich einer schematischen Darstellung. Ihre Anzahl ist von der verwendeten Übertragungstechnik abhängig. Für den Fall, dass differentielle Übertragungstechniken (wie beispielsweise Low Voltage Differential Signaling - LVDS) verwendet werden, ist eine größere Anzahl von Steckerkontakten erforderlich, als bei Single-Ended-Übertragungstechniken (wie beispielsweise unter Verwendung von CMOS-Technologie). Auch ist die konkrete Ausgestaltung der Steckerkontakte davon abhängig, ob die Datenübertragung beispielsweise mit einem Halb- oder einem Voll-Duplex-Verfahren erfolgt.

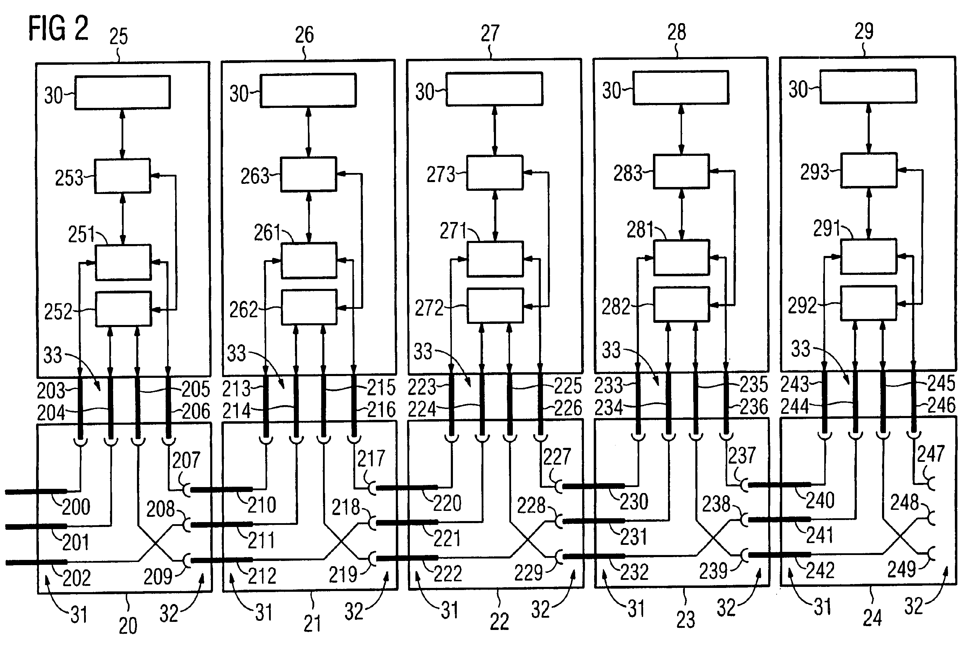

Eine schematische Darstellung der Busmodule und zugehöriger Baugruppen ist in FIG 2 abgebildet. Zur besseren Übersicht sind dabei die Versorgungsleitungen nicht dargestellt.

Die abgebildeten fünf Busmodule 20, 21, 22, 23, 24 und ihre Baugruppen 25, 26, 27, 28, 29 stellen nur einen Teil eines größeren Busmodul-Verbundes dar. Lediglich zu Illustrationszwecken wird angenommen, dass es sich bei der ersten Baugruppe 25 um eine Zentraleinheit (CPU) und bei den weiteren Baugruppen 26, 27, 28, 29 um Peripheriebaugruppen (Eingabebaugruppe, Ausgabebaugruppe, Regelungsbaugruppe und dergleichen) eines modularen Automatisierungsgeräts 1 handelt.

Jede Baugruppe 25, 26, 27, 28, 29 umfasst neben dem eigentlichen Controller 30 (beispielsweise in Form eines Mikrocontrollers) zur Ausführung der Baugruppenfunktion ein Hauptregister, ein Schattenregister und eine Entscheidungseinheit.

Diese Register werden von den bei der Datenübertragung zwischen den Baugruppen 25, 26, 27, 28, 29 übertragenen Daten durchlaufen.

Jedes Busmodul 20, 21, 22, 23, 24 verfügt über einen Eingangssteckverbinder 31 und einen Ausgangssteckverbinder 32 sowie über einen Steckverbinder 33 zur Kontaktierung der ihr zugeordneten Baugruppe 25, 26, 27, 28, 29. Dabei stellen die Übergangssteckverbinder 33 jeweils vier Verbindungen zwischen einem Busmodul 20, 21, 22, 23, 24 und einer Baugruppe 25, 26, 27, 28, 29 und die Eingangs- bzw. Ausgangssteckverbinder 31, 32 jeweils drei Verbindungen zwischen benachbarten Busmodulen 20, 21, 22, 23, 24 bereit.

Nachfolgend werden die Punkt-zu-Punkt-Verbindungen zwischen benachbarten Baugruppen 25, 26, 27, 28, 29 am Beispiel der mittleren drei Baugruppen 26, 27, 28 in FIG 2 beschrieben. Die Verbindungen sind für die Übertragung von Daten in beiden Richtungen ausgebildet.

Dabei ist der Eingangssteckverbinder 31 eines Busmoduls 2x mit dem Ausgangssteckverbinder 32 eines benachbarten Busmoduls verbunden, so dass die Ausgangskontakte 2x7, 2x8, 2x9 mit den Eingangskontakten 2x0, 2x1, 2x2 in Verbindung stehen. Die Übergangssteckverbinder 33 dienen der Herstellung von Kontakten 2x3, 2x4, 2x5, 2x6 zwischen dem Busmodul 2x und der Baugruppe.

Der erste Eingangskontakt 210 des zweiten Busmoduls 21 ist innerhalb des Busmoduls 21 mit der ersten Übergangsverbindung 213 zu der zweiten Baugruppe 26 und innerhalb der Baugruppe 26 mit deren Hauptregister 261 verbunden. Der zweite Eingangskontakt 211 des zweiten Busmoduls 21 ist innerhalb des Busmoduls 21 mit der zweiten Übergangsverbindung 214 zu der zweiten Baugruppe 26 und innerhalb der Baugruppe 26 mit deren Schattenregister 262 verbunden. Sowohl Hauptregister 261 als auch Schattenregister 262 sind innerhalb der zweiten Baugruppe 26 mit der Entscheidungseinheit 263 verbunden, die wiederum mit dem Controller 30 der zweiten Baugruppe 26 in Verbindung steht. Von dem Schattenregister 262 besteht Baugruppenintern eine Verbindung zu der dritten Übergangsverbindung 215 und von dort weiter durch das zweite Busmodul 21 hindurch zu einem dritten Ausgangskontakt 219 des Busmoduls 21. Ebenso besteht eine Verbindung zwischen dem Hauptregister 261 der zweiten Baugruppe 26 über die vierte Übergangsverbindung 216 in das zweite Busmodul 21 hin zu einem ersten Ausgangskontakt 217 des Busmoduls 21. Darüber hinaus verfügt das zweite Busmodul 21 über einen dritten Eingangskontakt 212, welche - ohne Verbindung zu der dem Busmodul 21 zugeordneten Baugruppe 26 - über eine Überbrückungsverbindung 100 mit einem zweiten Ausgangskontakt 218 des Busmoduls 21 verbunden ist. Diese Verbindung 100 dient, wie unten gezeigt werden wird, der Gewährleistung eines unterbrechungsfreien Betriebes für den Fall, dass die zweite Baugruppe 26 "gezogen", also von dem zweiten Busmodul 21 getrennt wird.

Das dritte Busmodul 22 mit der dazugehörigen dritten Baugruppe 27 ist in gleicher Art und Weise verschaltet. Die Ausgangskontakte 217, 218, 219 des zweiten Busmoduls 21 entsprechen dabei in ihrer Anordnung den Eingangskontakten 220, 221, 222 des dritten Busmoduls 22.

Die Verbindung 100 von dem Schattenregister 262 der zweiten Baugruppe 26 über die dritte Übergangsverbindung 215 und den dritten Ausgangskontakt 219 des zweiten Busmoduls 21 führt zu dem dritten Eingangskontakt 222 des dritten Busmoduls 22 und Busmodul-intern weiter zu dem zweiten Ausgangskontakt 228 des dritten Busmoduls 22. Diese Verbindung 100 dient also mit anderen Worten der Überbrückung der dritten Baugruppe 27. Von dem mit dem zweiten Ausgangskontakt 228 des dritten Busmoduls 22 verbundenen zweiten Eingangskontakt 231 des vierten Busmoduls 23 führt die Verbindung hin zu der zweiten Übergangsverbindung 234 des vierten Busmoduls 23 und innerhalb der vierten Baugruppe 28 weiter zu deren Schattenregister 282.

Ein Abschlusswiderstand am letzten Busmodul (nicht dargestellt) ist nicht erforderlich. Je nach gewählter Übertragungstechnik (LVDS, CMOS, ...) werden die Verbindungsleitungen auf den Peripherieleiterplatten intern abgeschlossen.

Im Betrieb des Automatisierungsgerätes 1 erfolgt die Übertragung von Daten von der ersten Baugruppe 25 (CPU-Baugruppe) seriell an die weiteren Baugruppen 26, 27, 28, 29. Üblicherweise erfolgt dabei die Datenübertragung von einem Hauptregister 251, 261, 271, 281, 291 einer Baugruppe 25, 26, 27, 28, 29 in das Hauptregister der benachbarten Baugruppe. Sind alle Baugruppen 25, 26, 27, 28, 29 im Bussystem gesteckt, dann erfolgt der Datenfluss beispielsweise von der zweiten Baugruppe 26 zu der vierten Baugruppe 28 wie folgt: Die Daten werden von dem Hauptregister 261 der zweiten Baugruppe 26 in das Hauptregister 271 der dritten Baugruppe 27 geschrieben. Von dem Hauptregister 271 der dritten Baugruppe 27 werden die Daten in das Hauptregister 281 der vierten Baugruppe 28 geschrieben.

Grundsätzlich prüfen alle Baugruppen selbst, ob Daten in ihrem Hauptregister bzw. ihrem Schattenregister vorliegen. Liegen im Schattenregister keine gültigen Daten vor, werden die Daten von dem Hauptregister in das Schattenregister transferiert. Liegen andererseits im Hauptregister keine gültigen Daten vor, werden die Daten von dem Schattenregister in das Hauptregister transferiert. Die Entscheidungseinheiten 253, 263, 273, 283, 293 stellen die Daten aus dem Hauptregister bzw. dem Schattenregister dem Controller 30 der Baugruppe zur Verfügung, sofern der Controller 30 der Empfänger der Daten ist. Zudem transferieren die Entscheidungseinheiten die Daten von dem Controller 30 in das Hauptregister und das Schattenregister, wenn der Controller 30 der Sender ist.

Wird nun beispielsweise die dritte Baugruppe 27 entfernt ("gezogen"), beispielsweise weil sie defekt ist und ausgewechselt werden soll, erfolgt der Datenfluss von der zweiten Baugruppe 26 zu der vierten Baugruppe 28 wie folgt: Die Daten werden von dem Schattenregister 262 der zweiten Baugruppe 26 in das Schattenregister 282 der vierten Baugruppe 28 geschrieben. Da in das Hauptregister 281 der vierten Baugruppe 28 keine Daten aus dem Hauptregister 271 der dritten Baugruppe 27 geschrieben werden, bleibt das Hauptregister 281 der vierten Baugruppe 28 leer. In diesem Fall schaltet die vierte Baugruppe 28 auf ihr Schattenregister 282 um. Ergibt die Prüfung des Schattenregisters 282, dass dort Daten vorliegen, transferiert die Entscheidungseinheit 283 der vierten Baugruppe 28 die im Schattenregister 282 der vierten Baugruppe 28 vorliegenden Daten in das Hauptregister 281 der vierten Baugruppe 28. Von dort aus werden die Daten dann über den gewöhnlichen Datenpfad an das Hauptregister 291 der fünften Baugruppe 29 weitergegeben.

Eine Datenübertragung beispielsweise von der vierten Baugruppe 28 zurück an die zweite Baugruppe 26 (bei "gezogener" dritter Baugruppe 27) erfolgt entsprechend über den gleichen Verbindungspfad von dem Schattenregister 282 der vierten Baugruppe 28 hin zu dem Schattenregister 262 der zweiten Baugruppe 26, wobei dann die Entscheidungseinheit 263 der zweiten Baugruppe 26 die Daten in das Hauptregister 261 der zweiten Baugruppe 26 transferiert.

Bei einem Hochlauf des Automatisierungsgerätes 1 stößt die erste Baugruppe 25 einen Verbindungsaufbau zu der zweiten Baugruppe 26 an. Empfängt die erste Baugruppe 25 eine Rückmeldung von der zweiten Baugruppe 26, vergibt sie eine Adresse an die zweite Baugruppe 26. Mit der Rückmeldung empfängt die erste Baugruppe 25 zugleich Informationen über den Typ der zweiten Baugruppe 26. Im Anschluss daran stößt die erste Baugruppe 25 über die zweite Baugruppe 26 einen Verbindungsaufbau zu der dritten Baugruppe 27 an usw.

Ist nun eine der Baugruppen, beispielsweise die dritte Baugruppe 27, nicht "gesteckt", wird der Hochlauf des Systems 1 nicht wie bei aus dem Stand der Technik bekannten seriell strukturierten Systemen abgebrochen. Vielmehr erfolgt ein vollständiger Hochlauf aller über das Bussystem 20, 21, 22, 23, 24 erreichbaren Baugruppen 25, 26, 28, 29. Somit kann auch bei einer fehlenden Baugruppe eine Übersicht über die angeschlossenen Baugruppentypen und zudem eine automatische Adressvergabe erfolgen, ohne dass manuelle Konfigurationen erforderlich sind.

Durch die erfindungsgemäße Ausgestaltung der Busmodule 20, 21, 22, 23, 24 ist für den Fall, dass keine der Baugruppen "gezogen" wird, eine gegenüber herkömmlichen Systemen erhöhte Datenübertragungsrate erzielbar.

In einem ersten Fall, in dem die CPU als Baugruppe 25 gesteckt ist, kann sie gleichzeitig zwei Verbindungen zu zwei Baugruppen betreiben. Dies ist zum einen eine erste Verbindung von dem Hauptregister 251 der Baugruppe 25 zu dem Hauptregister 261 der benachbarten Baugruppe 26 und zum anderen eine zweite Verbindung von dem Schattenregister 252 der Baugruppe 25 zu dem Schattenregister 272 der übernächsten Baugruppe 27.

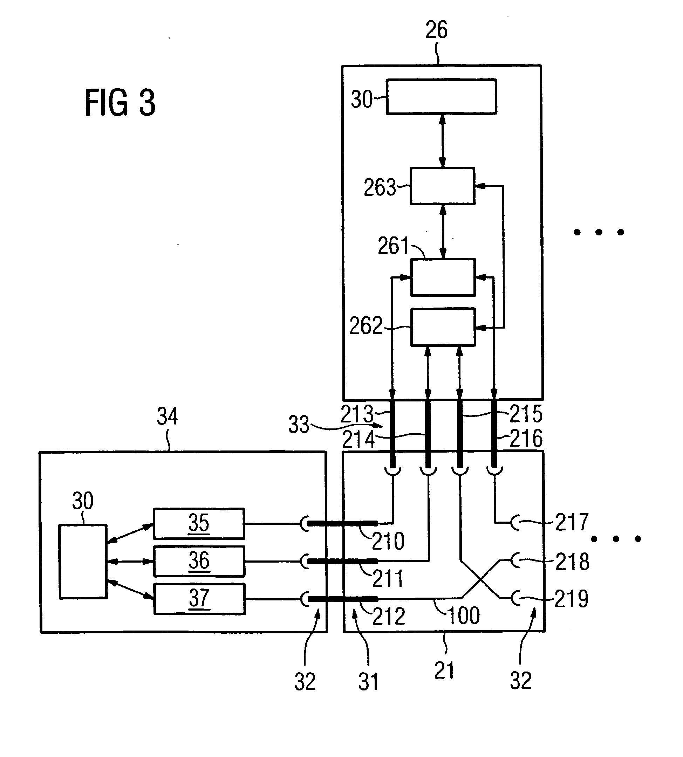

In einem zweiten Fall kann die CPU gleichzeitig drei Verbindungen zu drei Baugruppen betreiben. Hierzu ist eine CPU 34 mit drei Registern 35, 36, 37 vorgesehen, die anstelle des ersten Busmoduls 20 "gesteckt" wird. Eine solche Konfiguration ist ausschnittsweise in FIG 3 abgebildet.

Dabei verläuft die erste Verbindung von dem ersten Register 35 zu dem Hauptregister 261 der Baugruppe 26. Die zweite Verbindung verläuft von dem zweiten Register 36 über das Schattenregister 262 der Baugruppe 26 weiter zu dem Schattenregister 282 der Baugruppe 28. Die dritte Verbindung verläuft von dem dritten Register 37 zu dem Schattenregister 272 der Baugruppe 27. Mit anderen Worten ist die CPU 34 gleichzeitig mit drei Baugruppen 26, 27, 28 verbunden.

Dabei spielt die Position der zu verbindenden Baugruppen im Bussystem keine Rolle. So können die drei gleichzeitigen Verbindungen auch beispielsweise zu einer fünften, einer siebenten und einer neunten Baugruppe oder zu einer anderen beliebigen Komlaination von Baugruppen bestehen.

Zusammengefasst betrifft die Erfindung somit eine elektrische Anlage 1, insbesondere ein Automatisierungsgerät, wie beispielsweise eine speicherprogrammierbare Steuerung, mit einer Anzahl über Busmodule 20, 21, 22, 23, 24 elektrisch leitend miteinander verbindbarer Baugruppen 25, 26, 27, 28, 29. Um ein verbessertes Wartungsverhalten zu schaffen, wird eine Punkt-zu-Punkt-Verbindung 100 zwischen nicht unmittelbar benachbarten Baugruppen 25, 26, 27, 28, 29 vorgeschlagen. Die Anlage kann somit im Wartungsfall ohne Unterbrechung mit hoher Datenübertragungsrate weiter betrieben werden.

## Patentansprüche

1. Elektrische Anlage (1), insbesondere Automatisierungsgerät, mit Busmodulen (20, 21, 22, 23, 24), wobei jedes Busmodul eine Leiterplatte (5) und drei auf der Leiterplatte (5) angebrachte Steckverbinder (6, 7, 8) umfasst, und mit einer Anzahl über die Busmodule (20, 21, 22, 23, 24) elektrisch leitend miteinander verbindbarer Baugruppen (25, 26, 27, 28, 29),
- wobei im verbundenen Zustand jede Baugruppe (25, 26, 27, 28, 29) eine Punkt-zu-Punkt-Verbindung sowohl zu ihrer unmittelbar benachbarten Baugruppe, als auch zu deren benachbarter Baugruppe aufweist, sofern eine jeweils benachbarte Baugruppe vorhanden ist,
- wobei jede Baugruppe (25, 26, 27, 28, 29) ein Hauptregister (251, 261, 271, 281, 291) und ein Schattenregister (252, 262, 272, 282, 292) aufweist, wobei die Register von den bei einer Datenübertragung zwischen den Baugruppen (25, 26, 27, 28, 29) übertragenen Daten durchlaufen werden,
- wobei die Hauptregister (251, 261, 271, 281, 291) derart miteinander verbunden sind, dass eine Datenübertragung von einem Hauptregister (251, 261, 271, 281, 291) einer Baugruppe (25, 26, 27, 28, 29) in das Hauptregister einer benachbarten Baugruppe erfolgt,
- wobei jeweils die Schattenregister (252, 262, 272, 282, 292) zweier nicht unmittelbar benachbarter Baugruppen (25, 26, 27, 28, 29) über eine Punkt-zu-Punkt-Verbindung miteinander verbunden sind, sofern eine solche Baugruppe vorhanden ist, und
- wobei die Register miteinander verbunden sind derart, dass Daten von dem Schattenregister (252, 262, 272, 282, 292) in das Hauptregister (251, 261, 271, 281, 291) transferiert werden, wenn in dem Hauptregister (251, 261, 271, 281, 291) keine gültigen Daten vorliegen, und Daten vom Hauptregister (251, 261, 271, 281, 291) in das Schattenregister (252, 262, 272, 282, 292) transferiert werden, wenn keine gültigen Daten im Schattenregister (252, 262, 272, 282, 292) vorliegen.

2. Elektrische Anlage (1) nach Anspruch 1, **dadurch gekennzeichnet, dass** die Busmodule (20, 21, 22, 23, 24) ausschließlich passive Elemente aufweisen.

3. Elektrische Anlage (1) nach Anspruch 1, **dadurch gekennzeichnet, dass** die Anzahl der Baugruppen (25, 26, 27, 28, 29) variabel ist.

4. Verfahren zum Betrieb einer elektrischen Anlage (1), insbesondere eines Automatisierungsgerätes, bei dem eine Anzahl von Baugruppen (25, 26, 27, 28, 29) über Busmodule (20, 21, 22, 23, 24) elektrisch leitend miteinander verbunden werden, wobei jedes Busmodul eine Leiterplatte (5) und drei auf der Leiterplatte (5) angebrachte steckverbinder (6,7,8) umfasst,
- wobei im verbundenen Zustand von jeder Baugruppe (25, 26, 27, 28, 29) eine Punkt-zu-Punkt-Verbindung sowohl zu ihrer unmittelbar benachbarten Baugruppe, als auch zu deren benachbarter Baugruppe hergestellt wird, sofern eine jeweils benachbarte Baugruppe vorhanden ist,
- wobei jede Baugruppe (25, 26, 27, 28, 29) ein Hauptregister (251 261, 271, 281, 291) und ein Schattenregister (252, 262, 272, 282, 292) aufweist, wobei die Register von den bei einer Datenübertragung zwischen den Baugruppen (25, 26, 27, 28, 29) übertragenen Daten durchlaufen werden,
- wobei eine Datenübertragung von einem Hauptregister (251, 261, 271, 281, 291) einer Baugruppe (25, 26, 27, 28, 29) in das Hauptregister einer benachbarten Baugruppe erfolgt,
- wobei jeweils eine Punkt-zu-Punkt-Verbindung zwischen den Schattenregistern (252, 262, 272, 282, 292) zweier nicht unmittelbar benachbarter Baugruppen (25, 26, 27, 28, 29) hergestellt wird, sofern eine solche Baugruppe vorhanden ist, und
- wobei Daten von dem Schattenregister (252, 262, 272, 282, 292) in das Hauptregister (251, 261, 271, 281, 291) transferiert werden, wenn in dem Hauptregister (251, 261, 271, 281, 291) keine gültigen Daten vorliegen, und Daten vom Hauptregister (251, 261, 271, 281, 291) in das Schattenregister (252, 262, 272, 282, 292) transferiert werden wenn keine gültigen Daten im Hauptregister (251, 261, 271, 281, 291) vorliegen.

## Claims

1. Electrical installation (1), in particular automation device, comprising bus modules (20, 21, 22, 23, 24), with each bus module having a printed circuit board (5) and three plug-in connectors (6,7,8) attached thereto, and comprising a number of components (25, 26, 27, 28, 29) which can be connected to one another in an electrically conducting manner by way of the bus modules (20, 21, 22, 23, 24),
- whereby in the connected state, each component (25, 26, 27, 28, 29) has a point-to-point connection both to its directly adjacent component as well as to the latter's adjacent component, provided a respectively adjacent component exists,
- whereby each component (25, 26, 27, 28, 29) has a main register (251, 261, 271, 281, 291) and a shadow register (252, 262, 272, 282, 292), with the registers being passed through by the data transmitted during a data transmission between the components (25, 26, 27, 28, 29),
- whereby the main registers (251, 261, 271, 281, 291) are connected to one another such that a data transmission takes place from a main register (251, 261, 271, 281, 291) of a component (25, 26, 27, 28, 29) into the main register of an adjacent component,
- whereby the shadow registers (252, 262, 272, 282, 292) of two not directly adjacent components (25, 26, 27, 28, 29) are connected to one another in each instance by way of a point-to-point connection provided such a component exists and
- whereby the registers are connected to one another such that data is transferred from the shadow register (252, 262, 272, 282, 292) into the main register (251, 261, 271, 281, 291), if no valid data exists in the main register (251, 261, 271, 281, 291) and data is transmitted from the main register (251, 261, 271, 281, 291) into the shadow register (252, 262, 272, 282, 292) if no valid data exists in the shadow register (252, 262, 272, 282, 292).

2. Electrical installation (1) according to claim 1, **characterized in that** the bus modules (20, 21, 22, 23, 24) exclusively comprise passive elements.

3. Electrical installation (1) according to claim 1, **characterized in that** the number of components (25, 26, 27, 28, 29) is variable.

4. Method for operating an electrical installation (1), in particular an automation device, in which a number of components (25, 26, 27, 28, 29) are connected to one another in an electrically conducting manner by way of bus modules (20, 21, 22, 23, 24)
- whereby each bus module has a printed circuit board (5) and three plug-in connectors (6, 7, 8) attached to the printed circuit board (5),
- whereby in the connected state, a point-to-point connection is established from each component (25, 26, 27, 28, 29) both to its directly adjacent component as well as to the latter's adjacent component, provided a respectively adjacent component exists,
- whereby each component (25, 26, 27, 28, 29) has a main register (251, 261, 271, 281, 291) and a shadow register (252, 262, 272, 282, 292), with the register being passed through by data transmitted during a data transmission between the components (25, 26, 27, 28, 29),
- whereby a data transmission takes place from a main register (251, 261, 271, 281, 291) of a component (25, 26, 27, 28, 29) into the main register of an adjacent component,
- whereby a point-to-point connection is established in each instance between the shadow registers (252, 262, 272, 282, 292) of two not directly adjacent components (25, 26, 27, 28, 29), provided such a component exists, and
- whereby data is transferred from the shadow register (252, 262, 272, 282, 292) into the main register (251, 261, 271, 281, 291) if no valid data exists in the main register (251, 261, 271, 281, 291) and data is transferred from the main register (251, 261, 271, 281, 291) into the shadow register (252, 262, 272, 282, 292) if no valid data exists in the main register (251, 261, 271, 281, 291).

## Revendications

1. Equipement (1) électrique, notamment appareil d'automatisation, ayant des modules ( 20, 21, 22, 23, 24 ) de bus, chaque module de bus comprenant une plaquette ( 5 ) à circuit imprimé et trois connecteurs ( 6, 7, 8 ) montés sur la plaquette ( 5 ) à circuit imprimé et ayant un certain nombre de modules ( 25, 26, 27, 28, 29 ) pouvant être reliés entre eux d'une manière conductrice de l'électricité par l'intermédiaire des modules ( 20, 21, 22, 23, 24 ) de bus,
- dans lequel, à l'état relié, chaque module ( 25, 26, 27, 28, 29 ) a une liaison point à point tant à son module directement voisin qu'également au module voisin de celui-ci, dans la mesure où il y a un module respectivement voisin,
- dans lequel chaque module ( 25, 26, 27, 28, 29 ) a un registre ( 251, 261, 271, 281, 291 ) principal et un registre ( 252, 262, 272, 282, 292 ) en double, les registres étant parcourus par les données transmises lors d'une transmission de données entre les modules ( 25, 26, 27, 28, 29 ),
- dans lequel les registres ( 251, 261, 271, 281, 291 ) principaux sont reliés entre eux de manière à effectuer une transmission de données d'un registre ( 251, 261, 271, 281, 291 ) principale d'un module ( 25, 26, 27, 28, 29 ) au registre principal d'un module voisin,
- dans lequel respectivement les registres ( 252, 262, 272, 282, 292 ) en double de deux modules ( 25, 26, 27, 28, 29 ) qui ne sont pas directement voisins sont reliés par une liaison point à point, dans la mesure où il y a un module de ce genre, et
- dans lequel les registres sont reliés entre eux de façon à transférer des données du registre ( 252, 262, 272, 282, 292 ) en double au registre ( 251, 261, 271, 281, 291 ) principal, lorsqu'il n'y a pas de données valables dans le registre ( 251, 261, 271, 281, 291 ) principal, et à transférer des données du registre ( 251, 261, 271, 281, 291 ) principal au registre ( 252, 262, 272, 282, 292 ) en double, lorsqu'il n'y a pas de données valables dans le registre ( 252, 262, 272, 282, 292 ) en double.

2. Equipement ( 1 ) électrique suivant la revendication 1, **caractérisé en ce que** les modules ( 20, 21, 22, 23, 24 ) de bus ont exclusivement des éléments passifs.

3. Equipement ( 1 ) électrique suivant la revendication 1, **caractérisé en ce que** le nombre des modules ( 25, 26, 27, 28, 29 ) est variable.

4. Procédé pour faire fonctionner un équipement ( 1 ) électrique, notamment un appareil d'automatisation, dans lequel un certain nombre de modules ( 25, 26, 27, 28, 29 ) peuvent être reliés entre eux d'une manière conductrice de l'électricité par l'intermédiaire de modules ( 20, 21, 22, 23, 24 ) de bus, chaque module de bus comprenant une plaquette à circuit imprimé et trois connecteurs montés sur la plaquette ( 5 ) à circuit imprimé,
- dans lequel on ménage à l'état relié de chaque module ( 25, 26, 27, 28, 29 ) une liaison point à point tant à son module immédiatement voisin qu'également au module voisin de celui-ci, dans la mesure où il y a un module voisin,
- dans lequel chaque module ( 25, 26, 27, 28, 29 ) a un registre ( 251, 261, 271, 281, 291 ) principal et un registre ( 252, 262, 272, 282, 292 ) en double, les registres étant parcourus par les données transmises lors d'une transmission de données entre les modules ( 25, 26, 27, 28, 29 ),
- dans lequel on effectue une transmission de données d'un registre ( 251, 261, 271, 281, 291 ) principal d'un module ( 25, 26, 27, 28, 29 ) au registre principal d'un module voisin,
- dans lequel on ménage une liaison point à point entre les registres ( 252, 262, 272, 282, 292 ) en double et les deux modules ( 25, 26, 27, 28, 29 ) qui ne sont pas immédiatement voisins, dans la mesure où il y a un module de ce genre,
- dans lequel on transfère des données du registre ( 252, 262, 272, 282, 292 ) en double au registre ( 251, 261, 271, 281, 291 ) principal, lorsqu'il n'y a pas de données valables dans le registre ( 251, 261, 271, 281, 291 ) principal, et on transfère des données du registre ( 251, 261, 271, 281, 291 ) principal au registre ( 252, 262, 272, 282, 292 ) en double, lorsqu'il n'y a pas de données valables dans le registre ( 251, 261, 271, 281, 291 ) principal.
